# EUROPEAN PATENT SPECIFICATION

(11) **EP 2 276 070 B1**
(45) Date of publication and mention of the grant of the patent: **05.12.2012**
(21) Application number: 09734962.5
(22) Date of filing: 03.03.2009
(51) Int. Cl.: H01B 1/02, H01L 31/05

(54) **SOLAR CELL INTERCONNECTOR MATERIAL AND SOLAR CELL INTERCONNECTOR**
SOLARZELLENVERBINDUNGSMATERIAL UND SOLARZELLENVERBINDER
MATERIAU D'INTERCONNECTEUR DE CELLULE SOLAIRE ET INTERCONNECTEUR DE CELLULE SOLAIRE

(30) Priority: 25.04.2008 JP 2008115913
(43) Date of publication of application: 19.01.2011
(73) Proprietor: Mitsubishi Materials Corporation, Chiyoda-ku Tokyo 100-8117 (JP)
(72) Inventor: ISHIDA, Norikazu, Sakai-shi Osaka 592-8331 (JP); NAKAMOTO, Hitoshi, Sakai-shi Osaka 592-8331 (JP)
(74) Representative: HOFFMANN EITLE
(86) International application number: PCT/JP2009/053975
(87) International publication number: WO 2009/130949

(56) References cited:
- EP-A1- 0 296 596
- GB-A- 2 210 061
- JP-A- 1 234 537
- JP-A- 2 304 803
- JP-A- 11 021 660
- JP-A- 61 259 558
- JP-A- 2001 148 205
- JP-A- 2007 031 795
- JP-A- 2008 085 314
- JP-U- 64 025 929
- US-A- 4 871 399
- US-A- 5 077 005
- US-A1- 2003 089 518
- 'Taiyo Denchi-yo Nanshitsugata Handa Mekki Heikakusen no Kaihatsu' HITACHI DENSEN January 2007, pages 15 - 18

## Description

### [Technical Field]

The present invention relates to an interconnector for a solar battery and a material of the interconnector for a solar battery suitable for the interconnector for a solar battery which connects between cells in a solar battery module constituted of a plurality of cells.

### [Background Art]

In recent years, a method for generating electric power by utilizing a solar battery module has gained attention as a method having a lighter environmental impact, finding a wide variety of applications. The solar battery module, for example, described in Patent Document 1, is provided with a plurality of cells which are made with semiconductor boards such as silicon subjected to pn-junction and constituted in such a manner that these cells are electrically connected with interconnectors for a solar battery and bus bars.

Here, as an interconnector electrically connecting between cells, for example, as shown in Patent Document 2, widely used is that in which a solder coated layer is formed on a rectangular copper wire made of oxygen-free copper or tough pitch copper. Further, as shown in Non-Patent Document 1, there has been proposed an interconnector made of high purity copper of 6N (purity of 99.9999%).
[Patent Document 1] Japanese Unexamined Patent Application Publication No. 2005-166915
[Patent Document 2] Japanese Unexamined Patent Application Publication No. H11-21660
[Non-Patent Document 1] "Development of Solder Coated and Super Soft Annealed Copper Wire for Photovoltaic System" by Yuju Endo and five others, Hitachi Cable, Ltd., No. 26(2007-1), p.p. 15-18

### [Disclosure of the Invention]

### [Technical Problem]

Incidentally, the previously described solar battery module is always installed outdoors and, therefore, the temperature thereof rises up to about 90°C during the daytime when direct sunlight is radiated but drops down to about 0°C at night. In other words, solar battery cells and interconnectors for a solar battery are repeatedly subjected to a temperature cycle from 0°C to 90°C.
Here, since the above-described interconnector for a solar battery made of a rectangular copper wire is soldered to a cell made of silicon, thermal strain resulting from a difference between a coefficient of thermal expansion of the interconnector for a solar battery and that of the cell is accumulated inside the interconnector for a solar battery.

Since a conventional interconnector for a solar battery is, as described previously, constituted with oxygen-free copper and tough pitch copper, it becomes hardened due to the strain accumulated internally by temperature cycle from 0°C to 90°C, As described above, when the interconnector for a solar battery is hardened, a cell made of silicon which is a brittle material may be damaged or the interconnector for a solar battery itself may be damaged. Further, in order to obtain high purity copper of 6N, it is necessary to further refine cathode copper of 4 N (purity of 99.99%), thereby significantly increasing the production cost.
In particular, there have been recently developed a thin-type cell with an aim to produce a solar battery module at low cost, resulting in a higher possibility that the interconnector for a solar battery is hardened to result in damage of the cell.

Further, there is a difference in coefficients of thermal expansion between the cell constituted with silicon, etc., and the interconnector for a solar battery which is a rectangular copper wire. Where the interconnector for a solar battery is jointed to the cell, it is jointed to the cell in a state of being extended due to temperature elevation and the cell warps due to shrinkage of the interconnector for a solar battery when cooling, thereby posing a problem. There is such a disadvantage that where the cell warps, it is not possible that the cell is used to assemble a solar battery module or attached to a frame. There is also a possibility that the cell may be damaged by the warpage.

This invention has been made in view of the above situation, and an object of which is to provide an interconnector for a solar battery and a material of the interconnector for a solar battery which is installed and used outdoors, not hardened even where repeatedly subjected to a temperature cycle from 0°C to 90°C and capable of preventing troubles such as damage of a cell and that of the interconnector for a solar battery itself. Another object thereof is to provide an interconnector for a solar battery and a material of the interconnector for a solar battery capable of absorbing heat stress generated during solder jointing to prevent warpage of the cell.

### [Technical Solution]

In order to solve the above problem, the material of the interconnector for a solar battery in the present invention is a material of the interconnector for a solar battery used as an interconnector for a solar battery for connecting cells with each other in a solar battery module, in which at least one of Zr and Mg is contained in a range of 3 ppm or more and 20 ppm or less, O is contained in a range of 5 ppm or less in parts per million by mass, the balance consisting of Cu and inevitable impurities, and a residual resistance ratio is 300 or more.

Further, the interconnector for a solar battery in the present invention is an interconnector for a solar battery for connecting cells with each other in a solar battery module and which is made of the above-described material of the interconnector for a solar battery. The interconnector is a rectangular wire having a rectangular cross section in which a lead-free solder coated layer is formed on at least one of the principal faces extending in a direction in which the rectangular wire extends.

According to the thus comprised interconnector for a solar battery and the material of the interconnector for a solar battery, S (sulfur) present in copper as one of the inevitable impurities is adhered to Zr and Mg, by which softening temperature of the material of the interconnector can be decreased to 100°C or lower. Thereby, at the time when the temperature is elevated by direct sunlight, strain accumulated inside the interconnector for a solar battery is released, thus making it possible to prevent the interconnector for a solar battery from becoming hardened. It is, therefore, possible to prevent troubles such as damage of the cell and the interconnector for a solar battery itself.
Further, S (sulfur) is adhered to Zr and Mg, by which a crystal grain size can be increased. As described above, the crystal grain size is increased, thus making it possible to reduce the deformation resistance of the interconnector for a solar battery and suppress warpage of the cell during solder jointing.
Still further, in the present invention, the residual resistance ratio (RRR) of the material of an interconnector for a solar battery is 300 or more. Therefore, impurities such as solid solution of S (sulfur) in copper are smaller in quantity, thus making it possible to keep the softening temperature lower and also to increase the crystal grain size. It is noted that the residual resistance ratio (RRR) is a ratio of electric specific resistance ρ_{273K} at normal temperature (273K) to electric specific resistance ρ_{4.2K} at liquid helium temperature (4.2K), that is, ρ_{273K}/ρ_{4.2K}. As solid solution of impurities is reduced in quantity, the electric specific resistance ρ_{4.2K} at liquid helium temperature (4.2K) decreases. The residual resistance ratio (RRR) is, therefore, increased.
In addition, where Zr and Mg are less than 3 ppm, the above-described effects are not obtainable and where they are in excess of 20 ppm, the interconnector for a solar battery is decreased in electric conductivity. Therefore, at least one of Zr and Mg is contained in a range of 3 ppm or more and 20 ppm or less. Since O (oxygen) is also to be 5 ppm or less, it is possible to suppress the decrease in electric conductivity and prevent the loss of Zr and Mg resulting from oxidation which are easily oxidized elements. Further, Zr and Mg are added to generally available oxygen-free copper, thereby making it possible to produce the material of the interconnector for a solar battery in the present invention at lower cost.

The material of the interconnector for a solar battery may be 300 µm or more in average crystal grain size.
Further, at least one of Zr and Mg may be contained in a range of 10 ppm or more and 15 ppm or less.

### [Advantageous Effects]

According to the present invention, it is possible to provide an interconnector for a solar battery and a material of the interconnector for a solar battery which will not become hardened even where installed and used outdoors and repeatedly subjected to a temperature cycle from 0°C to 90°C, thereby preventing troubles such as damage of the cell and that of the interconnector for a solar battery itself. It is also possible to provide an interconnector for a solar battery and a material of the interconnector for a solar battery capable of preventing warpage of a cell by absorbing heat stress generated during solder jointing.

### [Brief Description of the Drawings]

[Fig. 1] is an explanation drawing for a solar battery module having an interconnector for a solar battery which is the present embodiment.
[Fig. 2] is a cross sectional view taken along line of X to X in Fig. 1.
[Fig. 3] is an explanation drawing for a solar battery cell provided on the solar battery module in Fig. 1.
[Fig. 4] is a cross sectional view taken along line Y to Y in Fig. 3.
[Fig. 5] is a pattern diagram schematically showing equipment for producing copper wire rods.

### [Description of Symbols]

30: solar battery module
31: solar battery cell
32: interconnector for a solar battery
33: lead-free solder coated layer

### [Best Mode for Carrying Out the Invention]

Hereinafter, an explanation will be made for an interconnector for a solar battery related to an embodiment of the present invention by referring to the attached drawings.

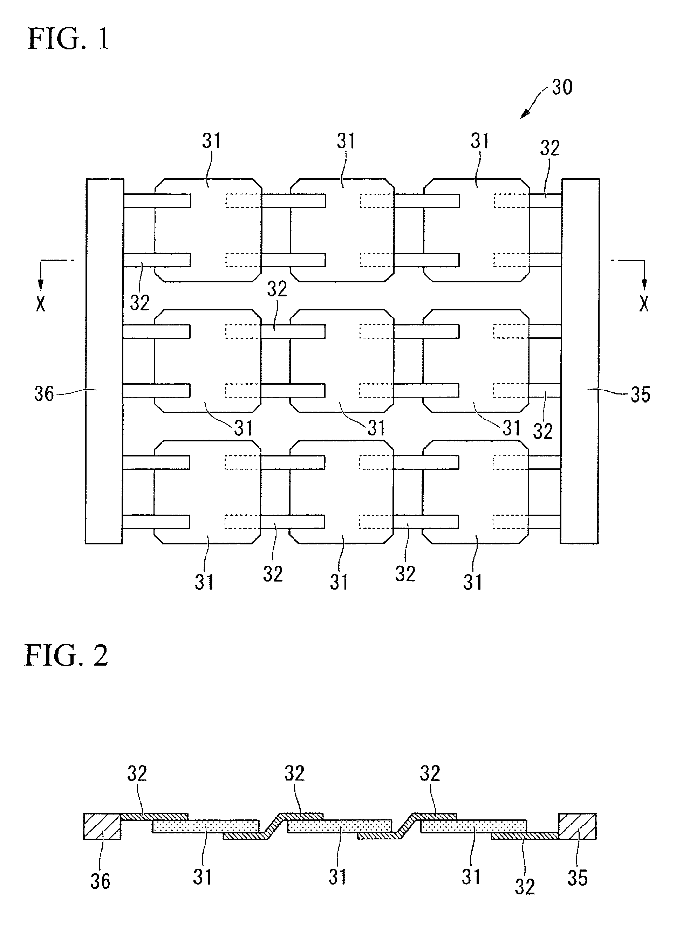

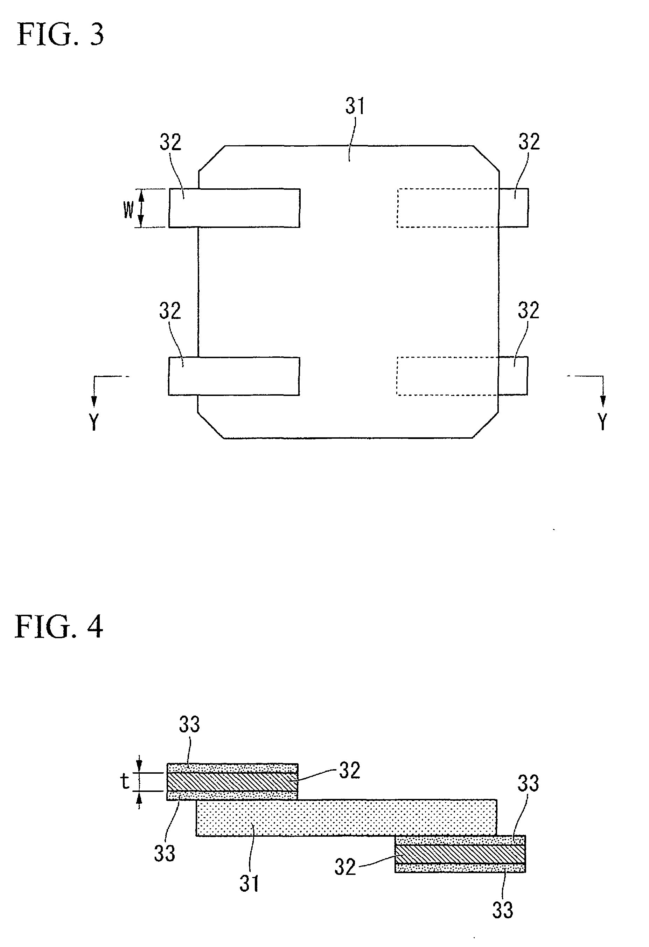

Fig. 1 and Fig. 2 show a solar battery module 30 using an interconnector for a solar battery 32 which is the present embodiment. Fig. 3 and Fig. 4 show a solar battery cell 31 which constitutes the solar battery module 30.
The solar battery module 30 shown in Fig. 1 and Fig. 2 is provided with a plurality of solar battery cells 31, interconnectors for a solar battery 32 for electrically connecting these solar battery cells 31 in series and bus bars 35, 36 to which the interconnectors for a solar battery 32 are connected.

The solar battery cell 31 is made of, for example, pn-junctioned silicon and formed substantially square shaped as shown in Fig. 3 and Fig. 4. In the present embodiment, the cell is 130 mm on one side and 0.18 mm in thickness.

The interconnectors for a solar battery 32 of the present embodiment are arrayed on the surface of the solar battery cell 31.
The interconnector for a solar battery 32 is a rectangular copper wire, having a rectangular cross section. In the present embodiment, the width W is 2 mm and the thickness t is 0.2 mm. As shown in Fig. 4, the interconnector for a solar battery 32 has a lead-free solder coated layer 33 which is formed on at least one of two principal faces extending in a direction in which the copper rectangular wire extends and which is joined to the solar battery cell 31 via the lead-free solder coated layer 33.
Then, the interconnector for a solar battery 32 is comprised of a material of the interconnector for a solar battery in which at least one of Zr and Mg is contained in a range of 3 ppm or more and 20 ppm or less, O is contained at 5 ppm or less in parts per million by mass, the balance consisting of Cu and inevitable impurities, and the residual resistance ratio (RRR) is 300 or more. Further, the average crystal grain size is 300 µm or more.

As shown in Fig. 1 and Fig. 2, the interconnectors for a solar battery 32 are jointed on the surface and the rear surface of the solar battery cell 31, thereby electrically connecting adj acent solar battery cells 31 with each other. Such a constitution is realized that the interconnectors for a solar battery 32 are connected respectively to the bus bar 35 which is a positive electrode and the bus bar 36 which is a negative electrode. All the solar battery cells 31 provided on the solar battery module 30 are connected in series by these interconnectors for a solar battery 32 and the bus bars 35, 36.

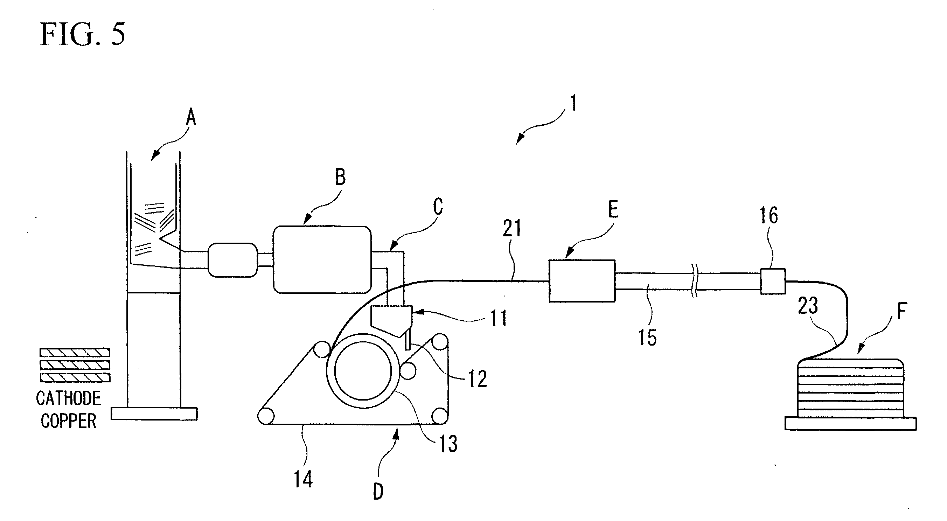

Next, an explanation will be made for a method for producing the material of the interconnector for a solar battery which is the present embodiment.
First, Fig. 5 shows one example of manufacturing equipment for producing a copper wire rod 23, that is, a raw material of the material of the interconnector for a solar battery which is the present embodiment. The manufacturing equipment 1 of producing the copper wire rod 23 is provided with a melting furnace A, a holding furnace B, a casting trough C, a belt wheel-type continuous casting machine D, a rolling machine E and a coiler F.

In the present embodiment, as the melting furnace A, used is a shaft furnace having a cylindrical furnace main body. A plurality of burners (not illustrated) is arranged at a lower part of the furnace main body vertically in a multistage manner in a circumferential direction. Cathode copper, which is a raw material, is loaded from an upper part of the furnace main body. The thus loaded raw material is melted through combustion of the burners to continuously produce molten copper.

The holding furnace B pools temporarily the molten copper produced at the melting furnace A, with a predetermined temperature kept, then feeding a certain quantity of the molten copper to the casting trough C.

The casting trough C transfers the molten copper fed from the holding furnace B to a tundish 11 arranged above the belt wheel-type continuous casting machine D. The casting trough C is sealed with, for example, an inert gas such as Ar or a reducing gas. It is noted that the casting trough C is provided with an agitation unit (not illustrated) for agitating the molten copper using the inert gas.

A molten copper feeding nozzle 12 is arranged at the dead end side of the tundish 11 in the flow direction of the molten copper, and the molten copper inside the tundish 11 is supplied to the belt wheel-type continuous casting machine D via the molten copper feeding nozzle 12.
The belt wheel-type continuous casting machine D is provided with a casting wheel 13 having a groove on an outer circumferential face and an endless belt 14 which is moved in an orbiting manner so as to be partially in contact with the outer circumferential face of the casting wheel 13. Then the molten copper supplied via the molten copper feeding nozzle 12 is poured into a space formed between the groove and the endless belt 14 and cooled, by which a bar-like ingot 21 is continuously cast.

The belt wheel-type continuous casting machine D is coupled to a rolling machine E. The rolling machine E continuously rolls the bar-like ingot 21 produced from the belt wheel-type continuous casting machine D, thereby producing a copper wire rod 23 with a predetermined outer diameter. The copper wire rod 23 produced from the rolling machine E is rolled up around the coiler via a washing/cooling apparatus 15 and a defect detector 16.

The washing/cooling apparatus 15 washes the surface of the copper wire rod 23 produced from the rolling machine E by using a detergent such as alcohol, and also cools the copper wire rod 23 by the detergent.
Further, the defect detector 16 detects flaws on the copper wire rod 23 fed from the washing/cooling apparatus 15.

Next, an explanation will be made for a manufacturing method for producing the material of the interconnector for a solar battery which is the present embodiment.
First, cathode copper of 4N (purity of 99.99%) is melted by feeding into the melting furnace A. Here, a plurality of burners provided on the shaft furnace are adjusted for an air-to-fuel ratio to give a reduction atmosphere inside the melting furnace A, thereby producing molten copper which is 20 ppm or less in oxygen content.

The molten copper obtained by the melting furnace A is transported via the holding furnace B and the casting trough C to the tundish.
Here, the molten copper passing through the casting trough C which is sealed with an inert gas or a reducing gas is agitated by the previously described agitation unit, thereby accelerating reactions of the molten copper with the inert gas or the reducing gas. Thereby, the oxygen content of the molten copper is decreased to 5 ppm or less.
At least one of Zr and Mg is continuously added to the molten copper which has decreased oxygen content of 5 ppm or less, and at least one of the Zr and Mg content is adjusted to be in a range of 3 ppm or more and 20 ppm or less. It is preferable that at least one of the Zr and Mg content is adjusted to be in a range of 10 ppm or more and 15 ppm or less.

The molten copper with added components is supplied to the belt wheel-type continuous casting machine D via the molten copper feeding nozzle 12, thereby continuously producing the bar-like ingot 21. Here, in the present embodiment, since a space between the previously described groove formed on the casting wheel 13 and the endless belt 14 is formed a trapezoid shape, there is produced a bar-like ingot 21 having a substantially trapezoidal cross section.

The bar-like ingot 21 is supplied to the rolling machine E and subjected to flat roll processing, thereby producing a copper wire rod 23 with a predetermined outer diameter (8 mm in the present embodiment). The copper wire rod 23 is washed and cooled by the washing/cooling apparatus 15 and inspected for the presence or absence of external flaws by the defect detector 16.

The thus obtained copper wire rod 23 with a diameter of 8 mm is subjected to wire drawing processing to produce a copper wire of 1 mm in diameter. Thereafter, the copper wire is formed with a rectangular shape with a thickness of 200 µm and a width of 2 mm by using a rolling machine, subjected to heat treatment at temperatures from 700°C or more and 800°C or lower for one minute or more and 10 minutes or less, thereby obtaining a material of the interconnector for a solar battery. The material of the interconnector for a solar battery is increased to 300 µm or more in average crystal grain size by the heat treatment process. Further, the residual resistance ratio (RRR) is increased to 300 or more by addition of at least one of Zr and Mg.

The material of the interconnector for a solar battery (copper rectangular wire) is soaked continuously into a Sn/Ag/Cu plating bath to form a plating layer. The material of the interconnector for a solar battery (copper rectangular wire) has a lead-free solder coated layer 33 all over on the surface, thereby producing the interconnector for a solar battery 32 which is the present embodiment. It is noted that in the present embodiment, the composition of the lead-free solder coated layer 33 are to be Sn -3.0% by mass of Ag - 0.5% by mass of Cu.

The solar battery module 30 provided with the thus constituted interconnectors for a solar battery 32 is arranged outdoors and used. Sunlight or the like are radiated at the solar battery cells 31 and the thus generated electricity is collected by the interconnectors for a solar battery 32 and the bus bars 35, 36. In the solar battery module 30 arranged outdoors, a temperature on the surface rises up to about 90 °C during the daytime when direct sunlight is radiated and drops down to about 0°C at night. The interconnectors for a solar battery 32 are repeatedly subjected to a temperature cycle from 0°C to 90°C.

The interconnector for a solar battery 32, which is the present embodiment, is comprised of a copper material in which at least one of Zr and Mg is contained in a range of 3 ppm or more and 20 ppm or less, O is contained at 5 ppm or less in parts per million by mass, and the balance is Cu and inevitable impurities. Therefore, S (sulfur) present in copper as one of the inevitable impurities is adhered to Zr and Mg, and the softening temperature is decreased to 100 °C or lower. Thereby, at the time when the temperature is elevated by direct sunlight, strain accumulated inside the interconnector for a solar battery 32 is released, thus making it possible to prevent the interconnector for a solar battery 32 from becoming hardened.

Further, since S (sulfur) is adhered to Zr and Mg, it is possible to make the crystal grain size be 300 µm or more. Thereby, the interconnector for a solar battery is decreased in deformation resistance, by which the cell is prevented from warping during solder jointing.
Still further, in the present embodiment, as the residual resistance ratio (RRR) is 300 or more, impurities such as solid solution of S (sulfur) in copper are lower in quantity. It is, therefore, possible to keep the softening temperature lower and also to increase the crystal grain size.

In addition, since the manufacturing equipment having the belt wheel-type continuous casting machine D and the rolling machine E is used to produce the copper wire rod 23 which is a raw material of the material of the interconnector for a solar battery, it is possible to produce the material of the interconnector for a solar battery at a lower cost. In the present embodiment, there is used a copper material on the basis of generally available oxygen-free copper of 4N (purity of 99.99%), thereby eliminating the necessity for special refining processing and also reducing the production costs for the material of the interconnector for a solar battery.

An explanation has been so far made for the embodiment of the present invention. However, the present invention shall not be limited thereto but may be modified in various ways within a scope not departing from the technical idea of the invention.
The explanation has been made by referring to, for example, a solar battery cell of 130 mm in length of one side and 0.18 mm in thickness. However, there is no particular limit to the size of the solar battery cell. Yet, cracks resulting from warpage may be easily developed in a thin-type solar battery cell with a thickness of 0.2 mm or less, thereby the effects of the interconnector for a solar battery which is the present embodiment become conspicuous.

Further, the explanation has been made by referring to the material of the interconnector for a solar battery which is produced by the manufacturing equipment having the belt wheel-type continuous casting machine D and the rolling machine E. However, the present invention shall not be limited thereto. It is also acceptable that, for example, a bar-like material obtained by subjecting a columnar ingot to extrusion processing is used to produce the material of the interconnector for a solar battery.

Still further, the explanation has been made by referring to a lead-free solder coated layer formed by electrifying a copper rectangular wire soaked in a plating bath. However, the present invention shall not be limited thereto. Other plating methods may be used to form a lead-free solder coated layer. It is noted that the lead-free solder coated layer may be formed on at least one of the principal faces extending in a direction in which a copper rectangular wire extends.
In addition, the composition of the lead-free solder coated layer is not limited to Sn - 3.0% by mass of Ag - 0.5% by mass of Cu. Other compositions are also acceptable.

### [Examples]

Hereinafter, an explanation will be made for results of a confirmation experiment conducted for confirming the effectiveness of the present invention.
In the confirmation experiment, there were provided the material of the interconnector for a solar battery, which is the previously described embodiment (examples 1 to 9 of the present invention), a copper material containing Zr and Mg, in which the content of Zr, Mg and O deviate from the present invention as comparative examples, an oxygen-free copper of 4N (a purity of 99.99%) as a conventional example, thereby preparing the test pieces with a thickness of 0.2 mm, a width of 2 mm and a length of 150 mm.

After these test pieces were subjected to heat treatment at 700°C for 10 minutes, measurement was made of the crystal grain size, the residual resistance ratio and the 0.2% proof stress.
Regarding the crystal grain size, S4300SE made by Hitachi High-Technologies Corporation was used to measure an average crystal grain size and the difference between maximum crystal grain size and minimum crystal grain size at ten sites in a visual field area of 5000 mm².
The residual resistance ratio (RRR) was calculated by measuring the electric specific resistance ρ_{273K} at normal temperature (273K) and the electric specific resistance ρ_{4.2K} at liquid helium temperature (4.2K) according to a four-terminal method.
Further, the 0.2% proof stress was measured by conducting a tensile test in reference to JIS Z 2241 by using AG-5kNX made by SHIMADZU CORPORATION.

Table 1 shows the measurement results.

[Table 1]

**[Table 1]**

| | Zr (ppm) | Mg (ppm) | O (ppm) | Balance | Residual resistance ratio (RRR) | Average crystal grain size (µm) | 0.2% proof stress (MPa) |
|---|---|---|---|---|---|---|---|
| Example 1 of the present invention | 5 | - | 3 | Cu + inevitable impurities | 310 | 310 | 50 |
| Example 2 of the present invention | 10 | - | 3 | Cu + inevitable impurities | 380 | 350 | 45 |
| Example 3 of the present invention | 20 | - | 3 | Cu + inevitable impurities | 370 | 380 | 42 |
| Example 4 of the present invention | - | 3 | 3 | Cu + inevitable impurities | 350 | 300 | 50 |
| Example 5 of the present invenlion | - | 10 | 3 | Cu + inevitable impurities | 400 | 360 | 45 |
| Example 6 of the present invention | - | 20 | 3 | Cu + inevilable impurities | 390 | 370 | 40 |
| Example 7 of the present invention | 5 | 5 | 3 | Cu + inevitable impurities | 420 | 360 | 43 |
| Example 8 of the present invention | 5 | 10 | 3 | Cu + inevitable impurities | 410 | 370 | 41 |
| Example 9 of the present invention | 10 | 5 | 3 | Cu + inevitable impurities | 400 | 360 | 41 |
| Comparative example 1 | 50 | - | 10 | Cu+mevitabie impurities | 250 | 160 | 80 |
| Comparative example 2 | - | 50 | 10 | Cu + inevitable impurities | 240 | 180 | 75 |
| Comparative example 3 | 30 | 30 | 10 | Cu -I- inevitable impurities | 210 | 170 | 85 |
| Conventional example | - | - | - | Oxygen-free copper of 4N | 250 | 100 | 85 |

As shown in Table 1, in the examples 1 to 9 of the present invention, it was confirmed that the residual resistance ratio was 300 or more, the average crystal grain size after heat treatment at 700°C for 10 minutes was 300 µm or more. It was also confirmed that the 0.2% proof stress was 50 MPa or less and the examples were sufficiently softened.
In contrast, in the comparative examples 1 to 3 and the conventional example, it was confirmed that even after heat treatment at 700°C for 10 minutes, the average crystal grain size was small, in a range of 100 µm or more and 180 µm or less, and the residual resistance ratio was less than 300. It was also confirmed that the 0.2% proof stress was in a range of 75 MPa or more and 85 MPa or less and these examples were not sufficiently softened.

Therefore, it was confirmed that according to the examples of the present invention, heat stress during solder jointing was sufficiently absorbed and cells could be prevented from warping.

Further, both ends of each of the test pieces were fixed on an aluminum plate, heated at 700°C, thereafter, subjected to a heat cycle of 0°C to 90°C, and measured for the 0.2% proof stress and Vickers hardness. Moreover, the test pieces were subjected to the following heat cycle 100 times: kept at 0°C for ten minutes in a sealed container, heated up to 90°C in one hour, kept at 90°C for 10 minutes, and cooled down to 0°C in one hour.

Table 2 shows the experiment results.

**[Table 2]**

| | Zr (ppm) | Mg (ppm) | O (ppm) | Balance | Residual resistance ratio (RRR) | 0.2% proof stress: Before heat cycle loaded | 0.2% proof stress: After heat cycle loaded |
|---|---|---|---|---|---|---|---|
| Example I of the present invention | 5 | - | 3 | Cu + inevitable impurities | 320 | 50 MPa | 51 MPa |
| Example 2 of the present invention | 10 | - | 3 | Cu + inevitable impurities | 380 | 45 MPa | 47 MPa |
| Example 3 of the present invention | 20 | - | 3 | Cu + inevitable impurities | 370 | 42 MPa | 45 MPa |
| Example 4 of the present invention | - | 3 | 3 | Cu + inevitable impurities | 350 | 50 MPa | 51 MPa |
| Example 5 of the present invention | - | 10 | 3 | Cu + inevitable impurities | 400 | 45 MPa | 47 MPa |
| Example 6 of the present invention | - | 20 | 3 | Cu + inevitable impurities | 390 | 40 MPa | 45 MPa |
| Example 7 of the present invention | 5 | 5 | 3 | Cu + inevitable impurities | 420 | 43 MPa | 46 MPa |
| Example 8 of the present invention | 5 | 10 | 3 | Cu+ inevitable impurities | 410 | 41 MPa | 44 MPa |
| Example 9 of the present invention | 10 | 5 | 3 | Cu + inevitable impurities | 400 | 41MPa | 45 MPa |
| Comparative example 1 | 50 | - | 10 | Cu + inevitable impurities | 250 | 80 MPa | 86 MPa |
| Comparative example 2 | - | 50 | 10 | Cu + inevitable impurities | 240 | 75 MPa | 85MPa |
| Comparative example 3 | 30 | 30 | 10 | Cu + inevitable impurities | 210 | 85MPa | 92 MPa |
| Conventional example | - | - | - | Oxygen-free copper of 4N | 250 | 85 MPa | 95 MPa |

As shown in Table 2, in the examples 1 to 9 of the present invention, it was confirmed that the 0.2% proof stress before the heat cycle loaded was in a range of 41 MPa or more and 50 MPa or less, while the 0.2% proof stress after the heat cycle loaded was in a range of 44 MPa or more and 51 MPa or less, they were not hardened by the temperature cycle. In contrast, in the comparative examples 1 to 3 and the conventional example, the 0.2% proof stress before the heat cycle loaded was in a range of 75 MPa or more and 85 MPa or less, while the 0.2% proof stress after the heat cycle loaded was in a range of 85 MPa or more and 95 MPa or less, and the test pieces were hardened by the heat cycle.

Therefore, according to the examples of the present invention, it was confirmed that where a solar battery module was arranged outdoors and subjected to a heat cycle from 0°C to 90°C, interconnectors for a solar battery were not hardened and solar battery cells were protected from breakage or the like.

### [Industrial Applicability]

According to the interconnector for a solar battery and the material of the interconnector for a solar battery in the present invention, the material of the interconnector can be decreased to 100°C or lower in softening temperature. Thereby, at the time when a temperature is elevated by direct sunlight, strain accumulated inside the interconnector for a solar battery is released, thus making it possible to prevent the interconnector for a solar battery from becoming hardened. It is, thus, possible to prevent troubles such as damage of a cell and the interconnector for a solar battery itself.
Further, since S (sulfur) is adhered to Zr and Mg, it is possible to increase the crystal grain size. The crystal grain size is increased as described above, by which the interconnector for a solar battery can be decreased in deformation resistance to prevent the cell from warping during solder jointing.
Still further, since the residual resistance ratio (RRR) is 300 or more, impurities in copper such as solid solution of S (sulfur) are lower in quantity, thus making it possible to keep the softening temperature lower and also to increase the crystal grain size.

## Claims

1. An interconnector (32) for a solar battery connecting between cells (31) with each other in a solar battery module (30), wherein
at least one of Zr and Mg is contained in a range of 3 ppm or more and 20 ppm or less, O is contained at 5 ppm or less in parts per million by mass, a balance consisting of Cu and inevitable impurities, and a residual resistance ratio is 300 or more.

2. The interconnector (32) for a solar battery according to claim 1 wherein
at least one of Zr and Mg is contained in a range of 10 ppm or more and 15 ppm or less in parts per million by mass.

3. The interconnector (32) for a solar battery according to claim 1 or claim 2, wherein
an average crystal grain size is 300 µm or more.

4. The interconnector (32) for a solar battery according to any one of claim 1 to claim 3 and which is a rectangular wire having a rectangular cross section, wherein
a lead-free solder coated layer (33) is formed on at least one of the principal faces extending in a direction in which the rectangular wire extends.

5. The interconnector (32) for a solar battery according to claim 3, wherein
the average crystal grain size is 380 µm or less.

6. The interconnector (32) for a solar battery according to claim 5 and which is a rectangula copper wire having a rectangular cross section, wherein
a lead-free solder coated layer (33) is formed on at least one of the principal faces extending in a direction in which the rectangular copper wire extends.

## Patentansprüche

1. Verbinder (32) für eine Solarbatterie, der Zellen (31) in einem Solarbatterie-Modul (30) miteinander verbindet, wobei zumindest eines von Zr und Mg in einem Bereich von 3 ppm oder mehr und 20 ppm oder weniger enthalten ist, O mit 5 ppm oder weniger pro Million Masseanteil enthalten ist, wobei ein Gleichgewicht von Cu und unvermeidlichen Verunreinigungen besteht, und ein Restwiderstandsverhältnis 300 oder mehr ist.

2. Verbinder (32) für eine Solarbatterie nach Anspruch 1, wobei
zumindest eines von Zr und Mg in einem Bereich von 10 ppm oder mehr und 15 ppm oder weniger pro Million Masseanteil enthalten ist.

3. Verbinder (32) für eine Solarbatterie nach Anspruch 1 oder Anspruch 2 wobei
eine durchschnittliche Kristallkorngröße 300 µm oder mehr ist.

4. Verbinder (32) für eine Solarbatterie nach einem von Anspruch 1 bis Anspruch 3, wobei dieser ein rechteckiger Draht mit einem rechteckigen Querschnitt ist, wobei
eine mit Blei-freiem Lötmaterial beschichtete Schicht (33) auf mindestens einer der Hauptflächen ausgebildet ist und sich in eine Richtung erstreckt, in die sich der rechteckige Draht erstreckt.

5. Verbinder (32) für eine Solarbatterie nach Anspruch 3, wobei
die durchschnittliche Kristallkorngröße 380 µm oder weniger ist.

6. Verbinder (32) für eine Solarbatterie nach Anspruch 5, wobei dieser ein rechteckiger Kupferdraht mit einem rechteckigen Querschnitt ist, wobei
eine mit Blei-freiem Lötmaterial beschichtete Schicht (33) auf mindestens einer der Hauptflächen ausgebildet ist und sich in eine Richtung erstreckt, in die sich der rechteckige Kupferdraht erstreckt.

## Revendications

1. Inter-connecteur (32) pour une batterie solaire connectant des cellules (31) les unes avec les autres dans un module (30) de batterie solaire, dans lequel
au moins l'un de Zr et Mg est présent dans une plage de 3 ppm ou plus et 20 ppm ou moins, O est présent à 5 ppm ou moins dans des parties par million en masse, un reste étant constitué de Cu et d'impuretés inévitables, et un rapport de résistance résiduelle est de 300 ou plus.

2. Inter-connecteur (32) pour une batterie solaire selon la revendication 1, dans lequel
au moins l'un de Zr et Mg est présent dans une plage de 10 ppm ou plus et 15 ppm ou moins dans des parties par million en masse.

3. Inter-connecteur (32) pour une batterie solaire selon la revendication 1 ou 2, dans lequel
une taille moyenne des grains cristallins est de 300 µm ou plus.

4. Inter-connecteur (32) pour une batterie solaire selon l'une quelconque des revendications 1 à 3 et qui est un fil rectangulaire ayant une coupe transversale rectangulaire, dans lequel
une couche (33) revêtue de brasure sans plomb est formée sur au moins l'une des faces principales s'étendant dans une direction dans laquelle s'étend le fil rectangulaire.

5. Inter-connecteur (32) pour une batterie solaire selon la revendication 3, dans lequel
la taille moyenne des grains cristallins est de 380 µm ou moins.

6. Inter-connecteur (32) pour une batterie solaire selon la revendication 5 et qui est un fil de cuivre rectangulaire ayant une coupe transversale rectangulaire, dans lequel
une couche (33) revêtue de brasure sans plomb est formée sur au moins l'une des faces principales s'étendant dans une direction dans laquelle s'étend le fil de cuivre rectangulaire.
